# DEMANDE DE BREVET EUROPEEN

(11) **EP 3 591 099 A1**
(43) Date de publication de la demande: **08.01.2020**
(21) Numéro de dépôt: 18181992.1
(22) Date de dépôt: 05.07.2018
(51) Int. Cl.: C25D 7/00, C04B 41/52, C23C 14/02, C25D 5/48, C23C 14/18, C23C 14/58, C23C 28/00, G04D 3/00, G04B 19/00, G04B 45/00

(54) **PROCEDE DE FABRICATION D'UNE PIECE EN CERAMIQUE REVETUE AU MOINS PARTIELLEMENT D'UNE COUCHE ELECTRIQUEMENT CONDUCTRICE**

(71) Demandeur: Comadur S.A., 2400 Le Locle (CH)
(72) Inventeur: Le Boudouil, Damien, 39290 Saint-Vivant Biarne (FR); Netuschill, Alexandre, 2414 Le Cerneux-Péquignot (CH)
(74) Mandataire: ICB SA

(57) **Abrégé**

L'invention concerne un procédé de fabrication d'une pièce (1) comprenant un substrat (2) réalisé dans une céramique à base de nitrure ou de carbure, le procédé comprenant successivement les étapes de :
a) Mise à disposition dudit substrat (2),
b) Formation d'une couche d'oxyde (5) en surface dudit substrat (2),
c) Dépôt d'une couche électriquement conductrice (6) sur au moins une partie de la surface comprenant la couche d'oxyde (5).
Selon l'invention, la formation de la couche d'oxyde permet d'améliorer l'adhérence entre le substrat en céramique à base de nitrure ou de carbure et la couche électriquement conductrice, cette dernière pouvant servir à un dépôt ultérieur d'une couche métallique extérieure.
L'invention concerne également la pièce qui comporte cette couche d'oxyde et au moins une couche électriquement conductrice déposée sur la couche d'oxyde.

## Description

### DOMAINE TECHNIQUE

La présente invention se rapporte à un procédé de fabrication d'une pièce, notamment d'un composant horloger, comprenant un substrat en céramique à base de nitrure ou de carbure. Plus particulièrement, l'invention se rapporte à un procédé de fabrication incluant une étape de traitement de surface permettant d'augmenter l'adhérence entre le substrat et une couche électriquement conductrice déposée ultérieurement.

### ART ANTERIEUR

Dans le domaine horloger, il est connu de réaliser des composants d'habillage tels que des boîtes de montre, des lunettes, etc., en céramique à base d'oxyde de zirconium, autrement dénommée zircone. Pour modifier les propriétés (densité, ténacité, etc.,) ou l'aspect esthétique du composant, il peut être souhaitable d'utiliser d'autres céramiques telles que le nitrure de silicium qui présente, entre autres, pour avantage d'être moins dense que la zircone, ce qui permet de fabriquer des composants qui sont légers tout en étant durs.

Ces composants d'habillage peuvent être décorés. Il peut s'agir d'un simple revêtement déposé par PVD qui modifie l'aspect esthétique du composant. De manière plus élaborée, il peut s'agir d'un dépôt galvanique d'un élément métallique au sein d'un évidement formé dans le composant pour réaliser un décor. A cet égard, le document EP 2 380 864 décrit un procédé de fabrication de lunettes de montre en céramique décorées avec des indices réalisés par dépôt galvanique d'un élément métallique au sein des évidements. Le procédé consiste à déposer deux couches d'accrochage électriquement conductrices par dépôt physique en phase vapeur (PVD) sur une face du support céramique comprenant les évidements. Une fois les couches d'accrochage déposées, les évidements sont remplis avec le matériau métallique par électroformage. Ce procédé est plus spécifiquement décrit et adapté pour un substrat céramique en zircone. En présence d'un substrat céramique à base de nitrure ou de carbure et non plus d'oxyde, le manque d'affinité chimique entre le substrat et la première couche conductrice peut engendrer des problèmes d'adhérence entre le substrat et ladite couche. Ce défaut d'adhérence entre le substrat et la couche conductrice peut mener à un décrochage local de la matière conductrice avec, pour corollaire, une croissance galvanique inégale sur le substrat. Ce manque d'adhérence peut également conduire à un enlèvement de la matière déposée lors d'une rectification ultérieure de la pièce.

### RESUME DE L'INVENTION

La présente invention a pour objet de proposer un procédé de fabrication d'une pièce incluant une étape de traitement de surface du substrat céramique à base non oxyde permettant d'augmenter l'adhérence entre le substrat et une couche déposée ultérieurement.

A cet effet, la présente invention propose de former en surface du substrat une couche d'oxyde améliorant l'affinité chimique entre le substrat et la couche déposée ultérieurement.

Préférentiellement, la couche d'oxyde est formée par oxydation thermique et a une épaisseur comprise entre 10 et 60 µm et plus préférentiellement entre 20 et 40 µm.

Ensuite, une première couche métallique ou, de manière plus générale, une première couche électriquement conductrice est déposée. Cette couche peut former un revêtement destiné à améliorer l'aspect esthétique de la pièce. Cette couche peut également servir de couche intermédiaire au sein d'un ensemble de couches formées sur la pièce.

Préférentiellement, le substrat est réalisé dans une céramique à base de nitrure de silicium et la première couche électriquement conductrice déposée est une couche de titane qui a très bonne adhésion sur la couche d'oxyde.

La meilleure adhérence obtenue grâce à la couche d'oxyde permet d'augmenter le nombre de couches déposées sur le substrat et d'améliorer le rendement d'un dépôt galvanique ultérieur le cas échéant. A cet égard, une deuxième couche électriquement conductrice, par exemple en or, est avantageusement déposée sur la première couche électriquement conductrice avant le dépôt galvanique d'une matière métallique également toujours à titre d'exemple en or. Préférentiellement, les différentes couches sont formées et déposées sur la paroi interne d'un évidement ménagé dans le substrat avant de remplir l'évidement avec la matière métallique pour former un décor affleurant à la surface du substrat.

D'autres caractéristiques et avantages de la présente invention apparaîtront dans la description suivante de modes de réalisation préférés, présentés à titre d'exemple non limitatif en référence aux dessins annexés.

### BREVE DESCRIPTION DES FIGURES

La figure 1 représente en plan une pièce, et en particulier, une lunette de montre comportant un substrat en céramique à base non oxyde et des indices réalisés avec le procédé de fabrication selon l'invention.
La figure 2 représente une vue partielle en coupe de cette même pièce.
La figure 3 illustre schématiquement l'étape de formation de la couche d'oxyde sur la surface du substrat à base de nitrure avec le procédé selon l'invention.
La figure 4 représente schématiquement les différentes couches formées ou déposées avec le procédé selon l'invention pour une variante préférée.
Les figures 5 à 8 représentent schématiquement les étapes de fabrication selon l'invention d'une pièce comprenant des évidements remplis par électroformage pour former des éléments décoratifs sur le substrat en céramique à base non oxyde.

### DESCRIPTION DETAILLEE

La présente invention se rapporte à un procédé de fabrication d'une pièce comprenant un substrat en céramique à base non oxyde. Elle est plus spécifiquement décrite pour un substrat à base de nitrure mais elle s'applique également aux substrats à base de carbure. La présente invention se rapporte plus particulièrement à l'étape mise en oeuvre pour améliorer l'adhérence entre le substrat et une couche électriquement conductrice déposée sur le substrat. Cette couche peut en soi être une finalité et être destinée à améliorer l'aspect esthétique de la pièce. En variante, cette couche peut être une couche intermédiaire utilisée pour ses propriétés de conductivité électrique en vue d'un dépôt galvanique ultérieur.

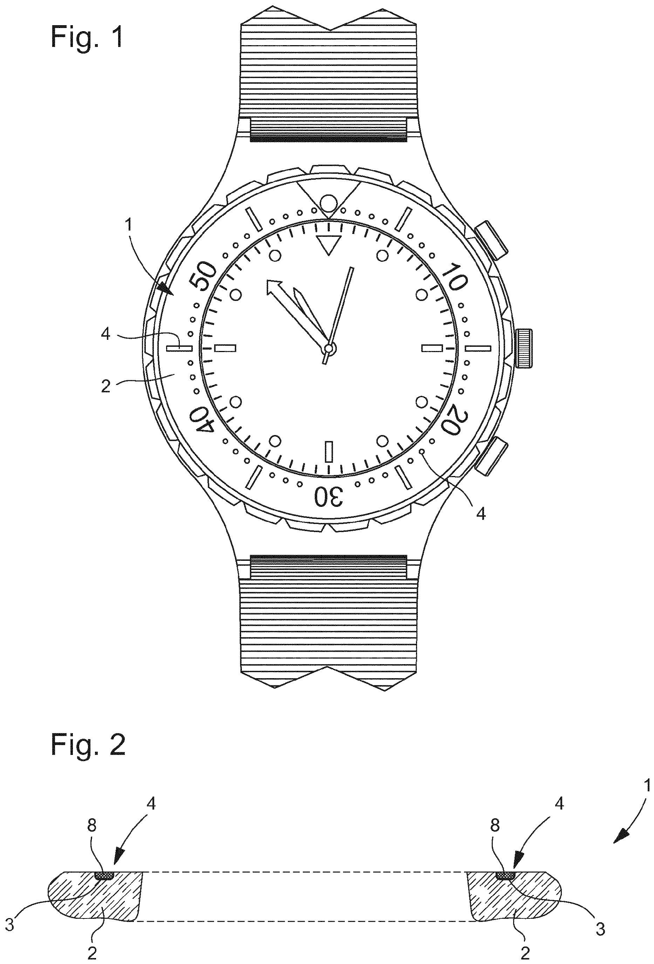

L'invention se rapporte également à la pièce issue du procédé de fabrication. La pièce peut notamment être un composant d'habillage en horlogerie tel qu'une lunette, un cadran, une boîte, une couronne, un poussoir, une glace, un élément de bracelet, etc. A titre d'exemple illustré à la figure 1, la pièce 1 est une lunette de montre comprenant un corps annulaire formant le substrat 2. Le substrat 2 comporte des évidements 3 visibles à la figure 2, remplis par électroformage avec un matériau métallique 8 pour former des éléments décoratifs 4 tels que des indices dans l'exemple illustré. Entre la surface du substrat et le matériau métallique, plusieurs couches sont présentes. Ces couches seront décrites plus en détail ci-après.

Le substrat est en céramique à base de nitrure ou de carbure. Selon la couleur ou les propriétés recherchées, il peut, par exemple, s'agir d'un nitrure de silicium (Si₃N₄), d'un nitrure de titane (TiN), d'un nitrure de bore (BN) ou d'un mélange de deux ou plus de ces céramiques. Pour un substrat à base de carbure, il peut, par exemple, s'agir d'un carbure de titane (TiC) ou de silicium (SiC). Le substrat est majoritairement (+80% en poids) à base de nitrure ou de carbure mais pourrait également contenir des oxydes tels que de l'oxyde d'yttrium et/ou de l'oxyde d'aluminium.

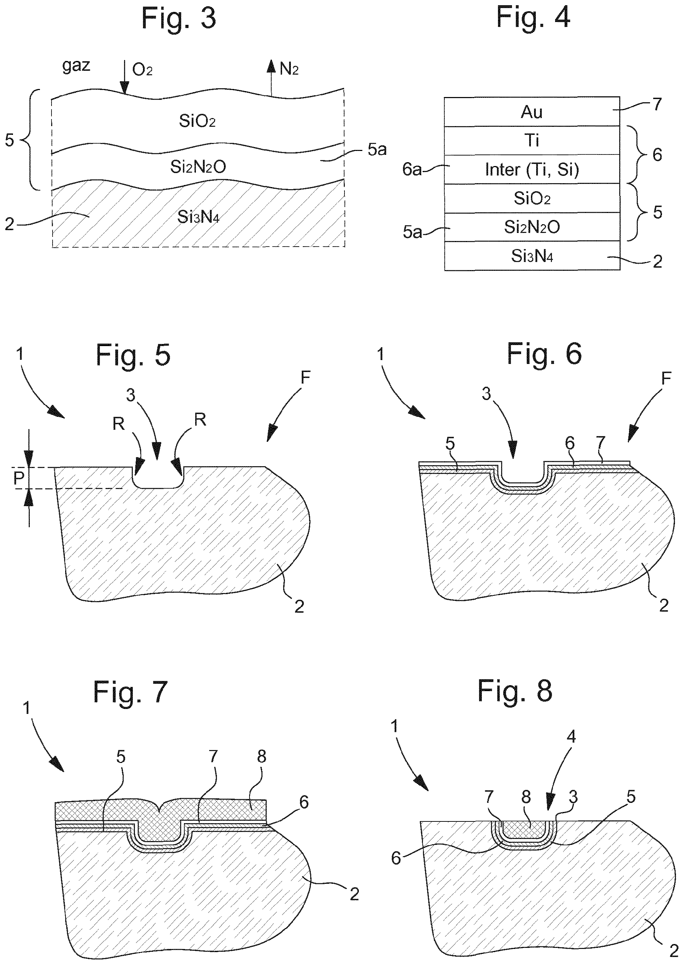

Selon l'invention, le procédé de fabrication de la pièce comprend une étape de traitement de la surface du substrat visant à améliorer l'adhérence sur la surface du substrat. Le traitement de surface consiste à former une couche d'oxyde sur cette surface. Plusieurs voies (chimique, thermique, plasma, etc.) sont envisageables pour former cette couche. Selon l'invention, le choix se porte préférentiellement sur la voie thermique aisément réalisable dans un four. Lors du chauffage, les atomes d'azote ou de carbone sont remplacés par des atomes d'oxygène. Il peut y avoir formation d'un composé mixte d'oxynitrure ou d'oxycarbure à l'interface respectivement entre le substrat en nitrure ou en carbure et la couche d'oxyde. Comme schématisé à la figure 3 pour un substrat 2 en nitrure de silicium (Si₃N₄), une couche d'oxyde de silicium 5 (SiO₂) se forme avec un composé mixte 5a de Si₂N₂O à l'interface avec la couche de Si₃N₄. Il est supposé que ce composé mixte améliore la cohésion entre les couches de SiO₂ et de Si₃N₄.

La couche d'oxyde incluant le composé mixte a préférentiellement une épaisseur comprise entre 10 et 60 µm et, plus préférentiellement, entre 20 et 40 µm, la température et le temps de recuit permettant d'adapter l'épaisseur de la couche. La température d'oxydation est choisie en fonction de la composition de la céramique. Pour une céramique à base de Si₃N₄, la température d'oxydation est préférentiellement comprise entre 850 et 1500°C et, plus préférentiellement, entre 1200 et 1300°C. Les temps de maintien sont fonction de la vitesse de chauffage jusqu'à la température d'oxydation précitée, l'oxydation pouvant débuter lors de la rampe de montée. Ces temps de maintien sont compris entre 0 et 6 heures et préférentiellement entre 1,5 et 3 heures. Un temps de maintien nul est envisageable si la vitesse de chauffage est suffisamment lente (< 200°C/h) que pour permettre l'oxydation jusqu'à l'épaisseur souhaitée lors de la montée en température. Pour une céramique à base de TiN, la température d'oxydation est préférentiellement comprise entre 500 et 900°C et plus préférentiellement entre 600 et 700°C pour des temps de maintien du même ordre. Pour des mélanges de céramiques à base non oxyde, la température d'oxydation est calquée sur la température d'oxydation la plus basse pour les différentes céramiques en présence. Les oxydations thermiques sont réalisées dans un four sous atmosphère ambiante.

Optionnellement, l'oxydation thermique du substrat peut être suivie d'une étape de dépôt par PVD d'une couche de l'oxyde correspondant du nitrure ou du carbure (SiO₂ pour Si₃N₄, TiO₂ pour TiN, etc.). Cette couche qui a une épaisseur de quelques dizaines de nanomètres permet de renforcer la couche d'oxyde formée.

Ensuite, une première couche électriquement conductrice est déposée sur la couche d'oxyde. Préférentiellement, elle est déposée par dépôt PVD et a une épaisseur comprise entre 20 et 70 nm et, plus préférentiellement, entre 40 et 60 nm avec typiquement une valeur sensiblement égale à 50 nm. Le matériau de cette couche est choisi en fonction de son affinité avec l'oxyde de la couche formée. A titre d'exemple, la couche est en Cr, Ni, Cu, Ti, Zr, TiW ou en NiP. Dans le cas d'un substrat en Si₃N₄, le choix se porte préférentiellement sur le titane qui est un élément réactif avec une forte adhésion sur la silice. Il est ainsi préférentiellement choisi car, par rapport à un autre métal réactif tel que le chrome, il est théoriquement plus réactif que ce dernier. Il est de plus thermodynamiquement possible que les oxygènes de la silice puissent réagir avec le titane métallique pour former un intermétallique permettant de renforcer la cohésion des couches.

Selon une variante, cette première couche forme un revêtement destiné à rester visible à des fins décoratives sur le substrat. Selon une autre variante préférée, cette première couche consiste en une couche intermédiaire en vue d'un dépôt galvanique ultérieur. Selon cette variante préférée, une seconde couche électriquement conductrice est déposée sur la première couche. Ce dépôt est également préférentiellement réalisé par PVD. A titre d'exemple, cette seconde couche peut, par exemple, être de l'or, du cuivre, de l'argent, de l'indium, du platine, du palladium ou du nickel. Elle est choisie pour sa capacité d'adhérence et est préférentiellement de nature similaire à celle du matériau métallique déposé ultérieurement par électroformage. Cette deuxième couche a préférentiellement une épaisseur comprise entre 20 et 70 nm, et plus préférentiellement entre 30 et 60 nm avec typiquement une valeur de 50 nm.

La figure 4 représente, de manière préférée, les différentes couches formées ou déposées avec le procédé selon l'invention pour un substrat 2 en Si₃N₄. Il y a formation de la couche 5 d'oxyde de silicium avec le composé mixte 5a d'oxynitrure à l'interface avec le substrat 2, ensuite dépôt de la première couche électriquement conductrice 6 de Ti avec formation probable d'un intermétallique 6a composé de Ti et de Si, ensuite dépôt de la deuxième couche électriquement conductrice 7 d'Au.

La surface du substrat est ainsi prête pour le dépôt d'un matériau métallique par électroformage. Le choix du matériau est varié. Selon le rendu visuel souhaité, le matériau déposé peut, à titre d'exemple, comporter de l'or, du cuivre, de l'argent, de l'indium, du platine, du palladium ou du nickel. Pour l'exemple préféré de la figure 4, le matériau choisi est l'or. Ce dépôt galvanique permet de déposer une couche d'épaisseur supérieure à 100 µm avec des valeurs typiquement de l'ordre de 200 µm.

Ensuite, la pièce est soumise à une rectification mécanique telle qu'un polissage pour retirer les différentes couches en dehors des zones comprenant les éléments décoratifs ou enlever un surplus de matière dans les zones comprenant les éléments décoratifs.

Ce procédé peut s'appliquer pour réaliser de nombreux décors sur le substrat en céramique. Revenant à l'exemple de la figure 1, le procédé de fabrication est illustré aux figures 5 à 8 pour la réalisation des indices 4 sur la lunette de montre constituant le substrat 2. A la figure 5, une partie du substrat 2 est visible. Ce substrat est muni d'au moins un évidement 3 d'une épaisseur P supérieure à 100 µm. Cet évidement peut, par exemple, être réalisé par gravage laser. Préférentiellement, chaque évidement est délimité par une paroi interne sans arête, représentée avec un rayon de courbure R à la figure 5, pour faciliter l'électroformage ultérieur. L'ensemble du substrat est ensuite soumis à l'oxydation thermique dans un four pour former la couche d'oxyde 5 d'une épaisseur de l'ordre de 30 µm (figure 6). Les deux couches conductrices 6,7 d'une épaisseur sensiblement égale à 50 nm sont ensuite déposées sur la face F du substrat comprenant l'évidement. Le dépôt des deux couches est préférentiellement réalisé par PVD au sein d'une enceinte. Ensuite, comme illustré à la figure 7, le dépôt du matériau métallique 8 est réalisé par électroformage sur la face F avec une épaisseur de la couche typiquement de l'ordre de 200 µm. Enfin, le procédé se termine en retirant la couche d'oxydes 5 et les dépôts 6,7,8 de la surface du substrat extérieur à l'évidement afin de n'en laisser qu'au niveau de l'évidement. Cette étape peut être réalisée par une méthode de surfaçage habituelle comme un meulage ou un rodage pour enlever le surplus de matière suivi d'un polissage. Ainsi, l'élément décoratif 4 affleure à la surface du substrat 2.

Le procédé a été illustré ici pour décorer un composant d'habillage en horlogerie mais il va de soi que cela s'applique de manière générale à toute pièce, y compris de bijouterie, où un décor est souhaité.

### Légende des figures

(1) Pièce
(2) Support
(3) Evidement
(4) Elément décoratif
(5) Couche d'oxyde
   a. Interface d'oxynitrure
(6) Première couche électriquement conductrice, aussi appelée première couche métallique
   a. Interface d'intermétallique
(7) Deuxième couche électriquement conductrice, aussi appelée deuxième couche métallique
(8) Couche galvanique, aussi appelée troisième couche métallique

## Revendications

1. Procédé de fabrication d'une pièce (1) comprenant un substrat (2) réalisé dans une céramique à base de nitrure ou de carbure, le procédé comprenant successivement les étapes de :
a) Mise à disposition dudit substrat (2),
b) Formation d'une couche d'oxyde (5) en surface dudit substrat (2),
c) Dépôt d'une première couche électriquement conductrice (6) sur au moins une partie de la surface comprenant la couche d'oxyde (5).

2. Procédé selon la revendication 1, **caractérisé en ce que** la couche d'oxyde (5) est formée à l'étape b) par oxydation thermique du substrat (2).

3. Procédé selon la revendication 2, **caractérisé en ce que** la couche d'oxyde (5) est formée à l'étape b) par oxydation thermique du substrat (2) suivie d'un dépôt en phase vapeur d'un même oxyde que celui obtenu lors de l'oxydation thermique.

4. Procédé selon la revendication 2 ou 3, **caractérisé en ce que**, pour un substrat en céramique à base de nitrure, l'étape b) est réalisée avec une température d'oxydation qui est, lorsque le substrat (2) comporte comme seul nitrure :
- du nitrure du silicium, comprise entre 850 et 1500°C et, de préférence, entre 1200 et 1300°C ;
- du nitrure de titane, comprise entre 500 et 900°C et, de préférence, entre 600 et 700°C ;
et qui est, lorsque le substrat (2) comporte plusieurs nitrures, égale à celle du nitrure ayant la plus basse température d'oxydation.

5. Procédé selon la revendication 4, **caractérisé en ce que** le temps de maintien à l'étape b) est compris entre 0 et 6 heures et, de préférence, entre 1,5 et 3 heures.

6. Procédé selon l'une quelconque des revendications précédentes, **caractérisé en ce que** lorsque le substrat (2) est en céramique à base de nitrure de silicium, la première couche électriquement conductrice (6) déposée lors de l'étape c) est en titane.

7. Procédé selon l'une quelconque des revendications précédentes, **caractérisé en ce qu'**il comporte en outre une étape d) de dépôt d'une deuxième couche électriquement conductrice (7) sur la première couche électriquement conductrice (6).

8. Procédé selon la revendication 7, **caractérisé en ce que** l'étape d) de dépôt de la deuxième couche électriquement conductrice (7) est suivie par une étape e) de dépôt d'un matériau métallique (8) par électroformage.

9. Procédé selon l'une quelconque des revendications précédentes, **caractérisé en ce que** l'étape c) est réalisée par dépôt en phase vapeur.

10. Procédé selon la revendication 7 ou 8, **caractérisé en ce que** l'étape d) est réalisée par dépôt en phase vapeur.

11. Procédé selon l'une quelconque des revendications 8 à 10, **caractérisé en ce que** le substrat (2) comporte sur sa surface au moins un évidement (3), la surface comportant ledit au moins évidement (3) étant soumise aux étapes b), c), d) et e) avec le matériau métallique (8) remplissant ledit au moins évidement (3) pour former un élément décoratif (4) sur le substrat (2).

12. Procédé selon l'une quelconque des revendications 8 à 11, **caractérisé en ce que** l'étape e) est suivie d'une étape f) de rectification pour enlever la couche d'oxyde (5), la première couche (6), la deuxième couche (7) ainsi que le matériau métallique (8) sur la surface du substrat (2) ne comprenant pas ledit au moins évidement (3).

13. Pièce (1) comprenant un substrat (2) réalisé avec une céramique à base de nitrure ou de carbure, **caractérisée en ce que** le substrat (2) comporte sur au moins une partie de sa surface plusieurs couches avec successivement une couche d'oxyde (5) et une première couche électriquement conductrice (6).

14. Pièce (1) selon la revendication 13, **caractérisée en ce que** le substrat (2) comporte en outre, à la suite de la première couche électriquement conductrice (6), une deuxième couche électriquement conductrice (7) et une troisième couche métallique (8).

15. Pièce (1) selon la revendication 13 ou 14, **caractérisée en ce que** le substrat (2) est une céramique à base de nitrure et comporte majoritairement du nitrure de silicium, du nitrure de titane, du nitrure de bore ou un mélange de deux ou plusieurs de ces nitrures.

16. Pièce (1) selon l'une quelconque des revendications 13 à 15, **caractérisée en ce que** la couche d'oxyde (5) comprend l'oxyde correspondant au nitrure ou au carbure de la céramique du substrat (2).

17. Pièce (1) selon la revendication 16, **caractérisée en ce que** la couche d'oxyde (5) comporte en outre un oxynitrure (5a) ou un oxycarbure à l'interface avec ladite au moins partie de surface du substrat (2).

18. Pièce (1) selon l'une quelconque des revendications 13 à 17, **caractérisée en ce que** la première couche électriquement conductrice (6) comprend du chrome, du nickel, du cuivre, du titane, du zirconium, du nickel-phosphore ou du titane-tungstène.

19. Pièce (1) selon l'une quelconque des revendications 14 à 18, **caractérisée en ce que** la deuxième couche électriquement conductrice (7) et la troisième couche métallique (8) comprennent respectivement de l'or, du cuivre, de l'argent, de l'indium, du platine, du palladium ou du nickel.

20. Pièce (1) selon l'une quelconque des revendications 13 à 19, **caractérisée en ce que** lorsque le substrat (2) est une céramique à base de nitrure de silicium, la couche d'oxyde (5) comporte de l'oxyde de silicium et la première couche électriquement conductrice (6) comporte du titane.

21. Pièce (1) selon la revendication 20, **caractérisée en ce que** la première couche électriquement conductrice (6) comporte du titane métallique et un intermétallique (5a) composé de titane et de silicium disposé à l'interface avec la couche d'oxyde (5).

22. Pièce (1) selon la revendication 20 ou 21, **caractérisée en ce que** la deuxième couche électriquement conductrice (7) et la troisième couche métallique (8) comportent de l'or.

23. Pièce (1) selon l'une quelconque des revendications 13 à 22, **caractérisée en ce que** la couche d'oxyde (5) a une épaisseur comprise entre 10 et 60 µm, de préférence entre 20 et 40 µm, et **en ce que** la première couche électriquement conductrice (6) a une épaisseur comprise entre 20 et 70 nm et, de préférence, entre 40 et 60 nm.

24. Pièce (1) selon l'une quelconque des revendications 14 à 22, **caractérisée en ce que** la deuxième couche électriquement conductrice (7) a une épaisseur comprise entre 20 et 70 nm, de préférence entre 40 et 60 µm, et **en ce que** la troisième couche métallique (8) a une épaisseur minimale de 100 µm.

25. Pièce (1) selon l'une quelconque des revendications 14 à 24, **caractérisée en ce que** le substrat (2) est muni d'au moins un évidement (3) comportant successivement sur sa paroi interne la couche d'oxyde (5), la première couche électriquement conductrice (6), la deuxième couche électriquement conductrice (7) et la troisième couche métallique (8) avec ladite troisième couche (8) remplissant entièrement ledit au moins évidement (3) pour former un élément décoratif (4) sur le substrat (2).

26. Pièce (1) selon l'une quelconque des revendications 13 à 25, **caractérisée en ce qu'**il s'agit d'un composant d'habillage en horlogerie ou en bijouterie.

27. Pièce (1) selon la revendication 26, **caractérisée en ce que** le composant est une lunette de montre formant le substrat (2) avec au moins un indice formant l'élément décoratif (4).

28. Montre ou bijou comportant la pièce (1) selon l'une quelconque des revendications 13 à 27.
